## Europäisches Patentamt
## European Patent Office
## Office européen des brevets

(19)

(11) Numéro de publication: **0 065 439**
**B1**

## (12) FASCICULE DE BREVET EUROPEEN

(45) Date de publication du fascicule du brevet:
27.12.84

(51) Int. Cl.³: **H 01 G 13/00**

(21) Numéro de dépôt: **82400759.5**

(22) Date de dépôt: **27.04.82**

(54) Bande support de connexions pour condensateur, bande munie de telles connexions, et son utilisation pour la fabrication de condensateurs.

(30) Priorité: **08.05.81 FR 8109230**

(43) Date de publication de la demande:
**24.11.82 Bulletin 82/47**

(45) Mention de la délivrance du brevet:
**27.12.84 Bulletin 84/52**

(84) Etats contractants désignés:
**AT DE GB NL**

(56) Documents cités:
**FR - A - 2 364 596**
**GB - A - 2 046 210**

(73) Titulaire: **L.C.C.-C.I.C.E. - COMPAGNIE EUROPEENNE DE COMPOSANTS ELECTRONIQUES, 50, rue Jean-Pierre Timbaud B.P. 301, F-92402 Courbevoie (FR)**

(72) Inventeur: **Mentzer, Régis, THOMSON-SCF SCPI 173, bld Haussmann, F-75379 Paris Cedex 08 (FR)**

(74) Mandataire: **Vesin, Jacques et al, THOMSON-CSF SCPI 173, Bld Haussmann, F-75379 Paris Cedex 08 (FR)**

ACTORUM AG

## Description

La présente invention concerne une bande-support de connexions pour condensateur ou analogues, une bande munie de telles connexions et son utilisation pour la fabrication de condensateurs.

Elle se rapporte plus particulièrement à une bande-support de connexions pour condensateur du type décrit dans la demande de brevet britannique GB-A N° 2046210 et comportant un support plan muni de paires d'encoches régulièrement réparties le long du support, chaque paire d'encoches étant formée d'une encoche supérieure et d'une encoche inférieure destinées à recevoir des connexions en forme d'épingle dont les deux bras latéraux traversent celles-ci, chaque condensateur devant être fixé entre les deux bras de l'épingle et sensiblement à l'extrémité de ceux-ci. Une telle technique de fixation de condensateurs à l'aide d'une bande munie d'épingles, telle que décrite ci-dessus est particulièrement utilisée dans le domaine de la fabrication des condensateurs plans, en particulier pour les condensateurs du type pavé. En effet, lorsqu'on fabrique des condensateurs, par exemple en céramique, constitués simplement de deux armatures métalliques séparées par un diélectrique, les connexions en forme d'épingle sont disposées sur chaque partie métallisée du disque. Il est donc nécessaire de réaliser dans ce cas un cambrage de ces connexions afin de les amener respectivement au-dessus et au-dessous dudit disque. Les deux connexions étant reliées entre elles pour former une épingle, elles exercent mutuellement l'une sur l'autre une réaction qui provoque un pincement du disque et un maintien de celui-ci entre les deux bras de ladite épingle, permettant une manipulation aisée au cours des stades suivants de fabrication desdits condensateurs. On peut malgré tout se heurter au problème du pivotement du disque entre les deux bras si l'on ne prend pas certaines précautions. Pour résoudre ce problème, on peut donner à l'épingle une forme telle que les forces appliquées par les bras soient situées dans un même plan. On peut également prévoir un cambrage desdits bras en dessous du disque afin d'éviter ledit pivotement.

Toutefois, dans les cas de condensateurs multicouches, le problème se pose différemment. En effet, les métallisations sur lesquelles les bras de l'épingle doivent s'appuyer ne sont plus dans ce cas disposées sur les faces supérieure et inférieure du condensateur mais disposées latéralement. Ces connexions généralement réalisées par schoopage, c'est-à-dire par projection de métal en fusion, sont par conséquent de faible épaisseur et de surface limitée, disposées latéralement par rapport ausdites faces supérieure et inférieure du condensateur.

Les épingles que l'on utilise sont alors disposées de telle sorte que chacun des bras de ladite épingle vienne au contact desdites surfaces de connexions ou schoopages. Lorsque le contact physique est établi entre l'extrémité des bras et les connexions, l'assemblage mécanique et électrique des deux s'effectue généralement par immersion dans un bain de soudure liquide. Au cours de cette opération, se posent différents problèmes techniques particulièrement difficiles à résoudre:
— le premier problème qui se pose est de maintenir une force d'application suffisante des bras sur les connexions électriques pour éviter qu'au cours de l'introduction et la sortie du condensateur dans le bain de soudure le pavé ne se désolidarise des bras;
— le second problème qui se pose est d'éviter au cours des mêmes opérations, non pas la désolidarisation des bras et du condensateur, mais une rotation de celui-ci par rapport à ceux-ci. Dans ce cas, en effet, comme dans le cas précédent, les condensateurs ainsi réalisés ne peuvent être ensuite utilisés.

Comme pour le cas des condensateurs disques en céramique, il a déjà été proposé, dans le cas de condensateurs multicouches, de réaliser un pliage ou un cambrage des bras de l'épingle, afin de réaliser un pincement du pavé et éviter ainsi les problèmes rencontrés ci-dessus. Toutefois, une telle solution présente un certain nombre d'inconvénients. En effet, le procédé de fabrication de ces condensateurs comporte ainsi au moins une étape supplémentaire, étape au cours de laquelle on réalise le cambrage ou le pliage de ces bras pour donner à l'épingle son effet de pincement. Compte tenu du prix extrêmement réduit de tels condensateurs, l'indice sur le prix de revient de ceux-ci d'une étape supplémentaire au cours du procédé de fabrication peut être déterminant et il est important de réduire celui-ci autant que faire se peut.

Dans ce but, la bande-support de connexions selon l'invention est caractérisée en ce que l'encoche supérieure est plus large que l'encoche inférieure, de telle sorte que l'épingle étant introduite avec la base du U située du côté de l'encoche supérieure, la pénétration des bras dans les encoches supérieure et inférieure provoque le resserrement progressif de ceux-ci.

De cette manière, on résout extrêmement simplement les problèmes posés ci-dessus. En effet, au cours de l'étape de fabrication desdits condensateurs au cours de laquelle on avance l'épingle de manière à mettre à proximité les bras d'une part et les connexions latérales du pavé d'autre part, le mouvement de l'épingle sur la bande provoque un resserrement progressif et continu de ceux-ci qui viennent pincer le pavé sur ses connexions latérales. On peut de cette manière aisément régler la force de pincement par pénétration plus ou moins importante de l'épingle dans les fentes. Généralement, la pénétration de celle-ci dans lesdits fentes étant d'une longueur prédéterminée afin de s'adapter aux machines automatiques bien connues de l'homme de l'art, on réglera par conséquent les largeurs respectives desdites fentes et leur position relative de manière à obtenir le résultat recherché suivant la nature, en particulier, des matériaux utilisés.

De préférence, chaque encoche supérieure sera disposée sensiblement au-dessus de l'encoche inférieure correspondante et sensiblement parallèlement au bord de la bande-support. Selon un mode préférentiel de réalisation, chaque encoche aura la forme d'un U dont les branches sont disposées parallèlement entre elles, les branches de chacune desdites encoches étant toutefois de préférence dirigées de l'encoche supérieure vers l'encoche inférieure.

Le rapport entre la largeur de l'encoche supérieure et celle de l'encoche inférieure dépend bien évidemment du type de condensateurs fabriqués et du type également d'épingle utilisée. En règle générale, la différence des largeurs entre l'encoche supérieure et l'encoche inférieure variera entre 0,05 mm et 5 mm, et de préférence entre 0,1 mm et 1 mm, pour une distance entre ces deux encoches de 15 mm. Celle-ci peut varier entre environ 5 mm et 30 mm, la différence des largeurs variant alors proportionnellement.

Dans tous les cas cependant, les largeurs respectives des encoches supérieures et inférieures seront inférieures ou égales à la distance séparant les bras de l'épingle lorsqu'ils sont mis parallèlement entre eux.

Afin de permettre à chaque épingle d'être utilisée sur le même poste, les encoches supérieures et les encoches inférieures seront respectivement alignées. Toutefois, il est possible de réaliser un décalage des ensembles d'encoches supérieures et inférieures les uns par rapport aux autres.

De même, les extrémités des branches de chaque encoche respectivement supérieure et inférieure seront généralement alignées les uns par rapport aux autres. De cette manière, et en particulier lorsque lesdites encoches ont la forme d'un U, la bande peut ainsi subir un pliage le long des extrémités des branches en forme de U, délimitant ainsi une cavité de hauteur sensiblement égale à la hauteur desdites branches. La hauteur de cette cavité sera généralement de l'ordre de l'épaisseur des bras de l'épingle, afin de permettre un déplacement aisé de celle-ci dans les encoches. Toutefois, les encoches en forme de U, dont les branches sont dirigées de l'encoche supérieure vers l'encoche inférieure, possèdent l'avantage particulier que la partie de la bande-support située entre les branches du U ayant la forme d'une languette joue ainsi le rôle d'entretoise entre lesdits bras de l'épingle, maintenant toujours entre eux l'écartement maximal et évitant un glissement de l'épingle en dehors de la bande. Afin d'améliorer encore ce résultat, l'encoche inférieure en forme de U aura une largeur légèrement inférieure au diamètre des bras de l'épingle, assurant ainsi la fonction de frein.

Les encoches réalisées sur la bande selon l'invention peuvent bien entendu prendre différentes formes de réalisation. Elles peuvent être continues et avoir la forme d'un U tel que cela a été décrit ci-dessus. Toutefois, lesdites encoches peuvent également être constituées d'une pluralité de sous-encoches. Le nombre de ces sous-encoches sera généralement égal à deux. Chaque sous-encoche aura une dimension du même ordre de grandeur que celui des bras des connexions en forme d'épingles. Dans le cas de bras cylindriques, qui est bien entendu la majorité des cas qui se présentent en pratique, ces sous-encoches pourront être simplement des trous de diamètre voisin de celui du diamètre du bras. La distance entre ces deux trous ne sera pas supérieure à la distance séparant les bras de l'épingle lorsqu'ils sont mis parallèlement l'un à l'autre. Au contraire, la distance entre les deux sous-encoches réalisant l'encoche inférieure sera inférieure à cette valeur. Dans le cas contraire, on constaterait en effet des contraintes au niveau des bras desdites épingles, préjudiciables au fonctionnement correct de celles-ci. De plus, bien entendu, la distance entre les deux sous-encoches supérieures sera supérieure à celle entre les sous-encoches inférieures.

Une autre variante possible desdites encoches est de réaliser également une pluralité de sous-encoches, de préférence deux, disposées en saillie sur la bande et ayant approximativement la forme d'un U également. De cette manière, le bras correspondant de l'épingle vient s'enficher dans le U et il suffit de prévoir un écartement suffisant entre les bras de ce U pour permettre un mouvement de translation du bras de l'épingle correspondant. Dans ce cas encore, les sous-encoches en saillie seront séparées d'une distance inférieure ou égale à la distance séparant les deux bras de l'épingle lorsque ceux-ci sont mis parallèlement l'un à l'autre, pour les mêmes raisons que celles exposées ci-dessus.

Les bandes munies d'épingles telles que décrites ci-dessus permettent donc d'améliorer de façon tout à fait intéressante les procédés de fabrication de condensateurs, en particulier de condensateurs empilés, supprimant ainsi une étape dans ledit procédé. Toutefois, on constate en pratique que les condensateurs parallélépipédiques possèdent bien souvent des faces latérales, sur lesquelles doivent être réalisées les connexions, qui ne sont pas parfaitement planes. Dans ce cas, on est quelquefois confronté encore au problème de rotation desdits condensateurs au cours de l'opération de soudure.

Dans ce but, un mode préférentiel de réalisation de l'invention consiste à munir l'extrémité des bras desdites épingles de moyens de fixation d'un condensateur. Parmi ces moyens, on peut citer de façon non limitative les solutions déjà connues qui consistent à réaliser un cambrage desdites pattes afin d'obtenir un meilleur contact entre l'ensemble des deux pattes et le condensateur.

Un mode particulièrement avantageux de réalisation consiste à réaliser un aplatissement de l'extrémité des bras qui forment ainsi un méplat, ce qui augmente la surface de contact entre ledit bras et les zones de connexions latérales du condensateur. Toutefois, la solution la plus avantageuse consiste ensuite à réaliser sur l'ensemble des deux méplats au moins trois bossages de façon à éviter les phénomènes de rotation au cours de la soudure. On constate, en effet, que dans ce cas, dans la mesure bien entendu où la force de pincement de l'épingle est suffisante, lesdits bossages pénètrent très légèrement dans lesdites connexions latérales et l'on réalise ainsi un ancrage mécanique des pattes de connexions sur le condensateur. Le nombre de bossages n'est bien entendu pas limité, mais compte tenu généralement des dimensions des condensateurs fabriqués, on préférera limiter ce nombre à cinq, étant entendu que la solution avec trois bossages donne des résultats particulièrement satisfaisants. Toutefois, il est possible de remplacer un ou deux bossages par le rebord inférieur du méplat formant un palier incliné. Dans ce cas, lédit méplat doit être réalisé bien entendu sur la face interne de l'extrémité du bras correspondant de l'épingle de manière à créer aux environs de sa base un petit rebord sur lequel vient s'appuyer le condensateur. Cette solution peut être adoptée pour les deux bras de l'épingle et, dans ces conditions, il suffit d'un seul bossage, par exemple à proximité de l'extrémité de l'un des méplats. Suivant le type de condensateur réalisé et le type de matériau utilisé, l'homme de l'art déterminera par de simples essais de routine la solution la mieux adaptée à son problème. Par ailleurs, il est bien entendu que l'un au moins des bossages peut être porté par le condensateur lui-même. En particulier, lorsque les condensateurs utilisés possèdent une face latérale très arrondie, celle-ci pourra être utilisée comme bossage. Dans ce cas, l'extrémité du bras correspondant de l'épingle sera simplement aplatie et éventuellement courbée de manière à suivre la courbure du bossage porté par le condensateur.

L'invention sera mieux comprise à l'aide des exemples de réalisation ci-joints donnés à titre non limitatif, conjointement avec les figures qui représentent:

la fig. 1, une vue de dessus d'une bande-support de connexions mise à plat et munie d'une pluralité d'encoches en forme de U,

la fig. 2, la bande telle que représentée sur la fig. 1 après pliage et insertion des épingles,

la fig. 3, une variante de réalisation des encoches disposées sur la bande-support,

la fig. 4, une deuxième variante de réalisation desdites encoches,

la fig. 5, une vue en coupe d'un condensateur pincé latéralement par les bras d'une épingle,

la fig. 6, une autre variante de réalisation de la fig. 5, dans laquelle les bras de l'épingle ont subi un cambrage.

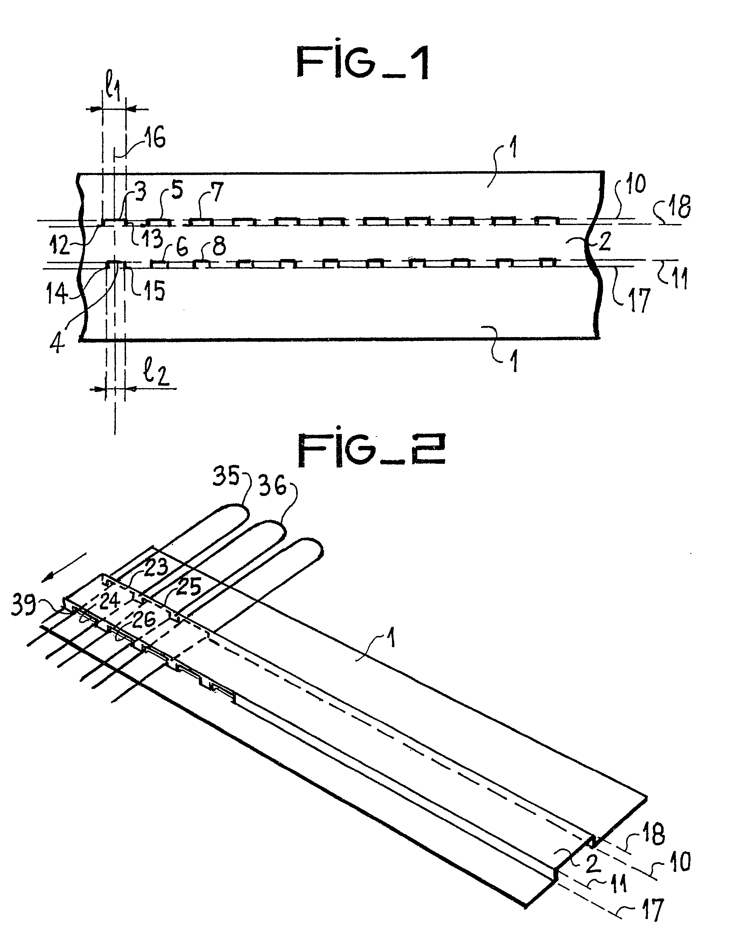

Sur la fig. 1 est représenté un exemple de réalisation d'une bande-support selon l'invention. Cette bande comprend une partie latérale 1 et une partie centrale 2 disposées entre les encoches 3 et 4, 5 et 6, 7 et 8, etc. Les encoches 3, 5, 7, etc., ont une largeur respective $1_1$ tandis que les encoches 4, 6, 8, etc., ont une largeur respective $1_2$. Ces séries d'encoches supérieures 3, 5, 7, etc., et inférieures 4, 6, 8, etc., sont respectivement alignées sur les lignes 10 et 11. Chacune de ces encoches a la forme d'un U dont les branches sont disposées vers le bas de la figure. Par exemple, l'encoche 3 possède deux bras latéraux 12 et 13 de même longueur, tandis que l'encoche 4 possède deux branches latérales 14 et 15 de même longueur et de longueur égale à celle de l'encoche 3. Ces encoches supérieures et inférieures sont disposées symétriquement par rapport à un axe vertical tel que l'axe 16 pour les encoches 3 et 4. L'encoche supérieure 3 a une largeur $1_1$ supérieure à la largeur $1_2$ de l'encoche inférieure 4. Comme cela a été mentionné ci-dessus, les dimensions respectives $1_1$ et $1_2$ ainsi que la distance entre les lignes 10 et 11 dépendent des cas particuliers envisagés et des machines utilisées. En règle générale, on souhaite ne pas avoir une convergence trop rapide des bras des épingles l'un vers l'autre au cours de l'utilisation. Par conséquent, les dimensions de $1_1$ et de $1_2$ seront relativement voisines, $1_2$ étant bien entendu inférieure à $1_1$. Les extrémités des branches des encoches de la rangée supérieure et des encoches de la rangée inférieure sont respectivement alignées sensiblement selon les lignes 18 et 17. Afin de faciliter l'insertion des épingles, la carte telle que représentée sur la fig. 1 subit un pliage le long des lignes 10, 18, 11 et 17. La carte ainsi obtenue possède donc un relief central 2 ainsi que cela est représenté sur la fig. 2 qui montre une vue en perspective de la carte revêtue de quelques épingles. Sur cette figure, les mêmes éléments que ceux de la figure précédente portent les mêmes références. Après pliage le long des lignes 10, 18, 11 et 17, on forme ainsi des languettes 23, 24, 25, 26, etc. Les languettes 23 et 25 sont situées dans le plan 2, tandis que les languettes 24 et 26 sont situées dans le plan 1. Les épingles telles que 35 et 36 sont introduites de la manière montrée sur la fig. 2, avec les extrémités des bras situées du côté des lignes 11 et 17. Les languettes 24 et 26 situées au niveau du plan 1 constituent par ailleurs des moyens d'écartement des bras desdites épingles. Bien entendu, la largeur des languettes 24 et 26 est inférieure à celle des languettes 23 et 25 donnant ainsi l'effet de resserrement des extrémités des bras des épingles 35 et 36 lors de leur translation dans le sens indiqué par la flèche sur la figure.

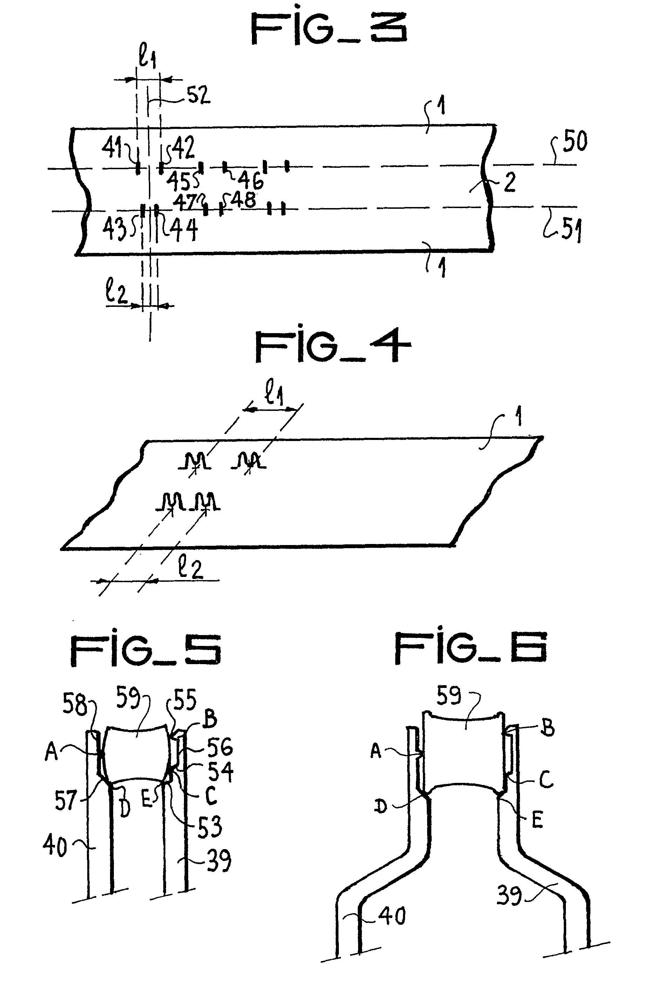

La fig. 3 représente une première variante de réalisation des moyens de guidage des bras des épingles telles que 35 et 36 afin d'assurer leur resserrement. Sur cette fig. 3, ces moyens de guidage ont été simplement réalisés à l'aide de perforations de diamètre sensiblement supérieur au diamètre des épingles afin de faciliter la pénétration de celles-ci. Les perforations 41, 42, 45, 46, etc., sont sensiblement alignées sur la ligne 50, tandis que les perforations inférieures 43, 44, 47, 48, etc., sont sensiblement alignées sur la ligne 51. Les perforations 41 et 42, 45 et 46, etc., sont distantes de $1_1$, tandis que les perforations 43 et 44, 47 et 48, etc., sont distantes de $1_2$. Comme précédemment, la distance $1_2$ est inférieure à la distance $1_1$. De préférence, ces perforations sont également disposées de façon sensiblement symétrique: les perforations 41, 42, 43 et 44 sont disposées symétriquement par rapport à l'axe vertical 52.

Sur la fig. 4 est représentée une deuxième variante de réalisation des moyens de guidage permettant d'obtenir l'effet selon l'invention. Sur cette variante, ces moyens de guidage sont constitués par des encoches disposées en saillie sur la bande-support 1. Ces encoches ont une gorge intérieure d'un diamètre sensiblement égal à celui des épingles telles que 35 et 36, ladite gorge se prolongeant également par deux branches se resserrant, ce qui évite bien entendu aux épingles 35 et 36 de se désolidariser du support 1 au cours de la manipulation.

D'autres variantes bien entendu peuvent être aisément réalisées par l'homme de l'art.

Sur la fig. 5 sont représentées les extrémités d'une épingle telle que 35, 36 présentant une forme particulière. Sur cette figure, les mêmes éléments que ceux des figures précédentes portent les mêmes références. Les bras 39 et 40 de l'épingle se terminent respectivement par un palier 53, un bossage 54 et un bossage 55 reliés au précédent par un palier 57 incliné, et un palier vertical 58. Les contacts entre le condensateur 59 et les extrémités de ces bras sont réalisés respectivement au point A, B, C, D et E. Le condensateur 59 s'appuie donc sur les deux paliers inclinés 53 et 57 tandis que les deux bossages 54 et 55 évitent tout problème de rotation du condensateur dans un plan perpendiculaire au plan de la figure. Bien entendu, un très grand nombre de variantes peut être envisagé pour ces extrémités: il est essentiel que dans tous les cas, il y ait au moins trois points de contact entre l'ensemble des deux branches et les connexions latérales du condensateur 59. En particulier, les paliers D et E ne sont pas nécessaires bien qu'ils facilitent grandement les opérations. Dans ce cas, le bras 40, par exemple au point A, sera muni d'un bossage afin d'améliorer l'ancrage du bras et de la connexion latérale du condensateur 59.

Les extrémités des bras 39 et 40 seront généralement réalisées par aplatissement de l'extrémité et de manière à former les deux paliers inclinés D et E disposés vers l'intérieur de l'épingle.

La fig. 6 représente une variante de la fig. 5, dans laquelle le condensateur 59 a une forme plus rectangulaire que dans le cas de la fig. 5. Les pattes 39 et 40 sont munies de cambrage afin de les mettre à un écartement conforme à la demande de l'utilisateur.

L'utilisation des bandes-supports munies d'épingles telles que décrites à l'aide des figures précédentes se fait de la même manière que les bandes-supports actuellement disponibles dans le commerce. Par translation des épingles dans la direction de la flèche (fig. 2), on provoque un resserrement des extrémités des bras qui viennent alors pincer les condensateurs tels que 59 sur leurs connexions latérales. La présence d'au moins trois points de contact sur l'ensemble des deux bras, à savoir A, B et C, évite ainsi au cours des opérations de fabrication suivantes une désolidarisation dudit condensateur desdites pattes ou une rotation de celui-ci rendant dans un cas comme dans l'autre inutilisables les condensateurs ansi fabriqués.

Il est bien entendu également que l'utilisation de l'invention n'est plus limitée aux seuls condensateurs: par ce terme, on a voulu désigner tout type de composant nécessitant une connexion par pincement et/ou soudure sur deux faces opposées de celui-ci.

## Revendications

1. Bande-support de connexions pour condensateur ou tout type de composant nécessitant une connexion par pincement et/ou soudure sur deux faces opposées de celui-ci, comportant un support plan muni de paires d'encoches régulièrement réparties le long du support, chaque paire d'encoches étant formée d'une encoche supérieure et d'une encoche inférieure, destinées à recevoir des connexions en forme d'épingle en U, dont les deux bras latéraux traversent lesdites encoches et sont guidés par celles-ci, chaque condensateur devant être fixé ensuite entre les deux bras de l'épingle et sensiblement à l'extrémité de ceux-ci, caractérisé en ce que l'encoche supérieure (3) est plus large que l'encoche inférieure (4), de telle sorte que l'épingle étant introduite avec la base du U située du côté de l'encoche supérieure, la pénétration des bras dans les encoches supérieure et inférieure provoque le resserrement progressif de ceux-ci.

2. Bande-support selon la revendication 1, caractérisé en ce que chaque encoche est constituée d'une pluralité de sous-encoches.

3. Bande-support selon l'une des revendications 1 ou 2, caractérisée en ce que chaque encoche ou sous-encoche est formée par une perforation.

4. Bande-support selon l'une des revendications 1 à 3, caractérisée en ce que chaque encoche ou sous-encoche est formée par une partie en saillie se resserrant autour des bras de l'épingle.

5. Bande-support selon l'une des revendications 1 à 4, caractérisée en ce que chaque encoche supérieure est disposée sensiblement au-dessus de l'encoche inférieure correspondante et sensiblement parallèlement au bord de la bande-support.

6. Bande-support selon l'une des revendications 1 à 5, caractérisée en ce que chaque encoche a la forme d'un U dont les branches sont disposées parallèlement entre elles.

7. Bande-support selon la revendication 6, caractérisée en ce que les branches de chaque encoche sont dirigées de l'encoche supérieure vers l'encoche inférieure.

8. Bande-support selon l'une des revendications 1 à 7, caractérisée en ce que, proportionnellement, la différence entre la largeur de l'encoche supérieure et celle de l'encoche inférieure varie entre 0,05 mm et 5 mm, et de préférence entre 0,1 mm et 1 mm, pour une distance entre encoches égale à 15 mm.

9. Bande-support selon l'une des revendications 6 à 8, caractérisée en ce que les encoches supérieures et les encoches inférieures sont respectivement alignées.

10. Bande-support selon la revendication 9, caractérisée en ce que les extrémités des branches de chaque encoche respectivement supérieure et inférieure sont alignées.

11. Bande-support selon la revendication 10, caractérisée en ce qu'elle a subi un pliage le long des extrémités des branches d'encoche en forme de U, délimitant ainsi une cavité de hauteur sensiblement égale à la hauteur des branches d'encoche en forme de U.

12. Bande-support selon l'une des revendications 1 à 11, munie d'au moins une épingle disposée dans les encoches correspondantes, caractérisée en ce que les extrémités des bras desdites épingles possèdent des moyens de fixation d'un condensateur.

13. Bande-support selon la revendication 12, caractérisée en ce que les moyens de fixation sont des cambrages des bras.

14. Bande-support selon l'une des revendications 12 ou 13, caractérisée en ce que les moyens de fixation sont réalisés par aplatissement de l'extrémité du bras formant ainsi un méplat.

15. Bande-support selon la revendication 14, caractérisée en ce que l'ensemble des méplats possède au moins trois bossages.

16. Bande-support selon la revendication 15, dans laquelle chaque méplat est disposé de telle sorte qu'il existe un palier inférieur dirigé vers l'autre bras sur lequel peut s'appuyer un condensateur.

17. Bande-support selon l'une des revendications 1 à 16, caractérisée en ce que les largeurs respectives des encoches supérieures et inférieures sont inférieures ou égales à la distance séparant les bras de l'épingle lorsqu'il sont mis parallèlement entre eux.

18. Utilisation d'une bande-support selon l'une des revendications précédentes pour la fabrication de condensateurs.

**Patentansprüche**

1. Trägerband von Anschlüssen für Kondensatoren oder jegliche Art von Bauteil, die Anschluss durch Einklemmen und/oder Anlöten an zwei einander gegenüberliegenden Flächen desselben benötigen, mit einem ebenen Träger, der mit Paaren von regelmässig längs des Trägers verteilten Ausschnitten versehen ist, wobei jedes Paar von Ausschnitten aus einem oberen Ausschnitt und einem unteren Ausschnitt gebildet ist, die dazu bestimmt sind, U-nadelförmige Anschlüsse aufzunehmen, deren zwei seitliche Schenkel die genannten Ausschnitte durchqueren und durch diese geführt werden, wobei jeder Kondensator anschliessend zwischen den beiden Schenkeln der Nadel und im wesentlichen am Ende derselben befestigt werden muss, dadurch gekennzeichnet, dass der obere Ausschnitt (3) breiter ist als der untere Ausschnitt (4), so dass beim Einführen der Nadel mit dem Fussteil U auf der Seite des oberen Ausschnittes liegend das Eindringen der Schenkel in den oberen Ausschnitt und den unteren Ausschnitt das progressive Gegeneinanderdrücken derselben verursacht.

2. Trägerband nach Anspruch 1, dadurch gekennzeichnet, dass jeder Ausschnitt aus einer Mehrzahl von Unterauschnitten gebildet ist.

3. Trägerband nach einem der beiden Ansprüche 1 oder 2, dadurch gekennzeichnet, dass jeder Ausschnitt oder Unterausschnitt durch eine Perforierung gebildet ist.

4. Trägerband nach einem der Ansprüche 1 bis 3, dadurch gekennzeichnet, dass jeder Ausschnitt oder Unterausschnitt durch einen hochstehenden Teil gebildet ist, der um die Schenkel der Nadel herumgespannt ist.

5. Trägerband nach einem der Ansprüche 1 bis 4, dadurch gekennzeichnet, dass jeder obere Ausschnitt im wesentlichen über dem unteren entsprechenden Ausschnitt und im wesentlichen parallel zum Rand des Trägerbandes angeordnet ist.

6. Trägerband nach einem der Ansprüche 1 bis 5, dadurch gekennzeichnet, dass jeder Ausschnitt die Form eines U besitzt, dessen Schenkel zueinander parallel angeordnet sind.

7. Trägerband nach Anspruch 6, dadurch gekennzeichnet, dass die Schenkel jedes Ausschnittes von dem oberen Auschnitt zu dem unteren Ausschnitt gerichtet sind.

8. Trägerband nach einem der Ansprüche 1 bis 7, dadurch gekennzeichnet, dass, in proportionaler Weise, die Differenz zwischen der Breite des oberen Ausschnittes und der des unteren Ausschnittes zwischen 0,05 und 5, vorzugsweise zwischen 0,1 und 1 mm variiert, für einen Abstand zwischen den Ausschnitten von 15 mm.

9. Trägerband nach einem der Ansprüche 6 bis 8, dadurch gekennzeichnet, dass die oberen Ausschnitte und die unteren Ausschnitte jeweils miteinander fluchten.

10. Trägerband nach Anspruch 9, dadurch gekennzeichnet, dass die Enden der Schenkel jedes Ausschnittes, des oberen und unteren, jeweils miteinander fluchten.

11. Trägerband nach Anspruch 10, dadurch gekennzeichnet, dass es eine Faltung längs den Enden der Schenkel der U-förmigen Ausschnitte erhalten hat, wodurch ein Hohlraum einer Höhe gebildet wird, die im wesentlichen gleich der Höhe der Schenkel der U-förmigen Ausschnitte ist.

12. Trägerband nach einem der Ansprüche 1 bis 11, welches mit wenigstens einer Nadel versehen ist, die in den entsprechenden Ausschnitten angeordnet ist, dadurch gekennzeichnet, dass die Enden der Schenkel der Nadeln Mittel zur Befestigung eines Kondensators besitzen.

13. Trägerband nach Anspruch 12, dadurch gekennzeichnet, dass die Befestigungsmittel Biegungen der Schenkel sind.

14. Trägerband nach einem der Ansprüche 12 oder 13, dadurch gekennzeichnet, dass die Befestigungsmittel durch Abflachung des Endes der Schenkel gebildet sind, wodurch eine flache Kontaktfläche gebildet ist.

15. Trägerband nach Anspruch 14, dadurch gekennzeichnet, dass die Gesamtheit der flachen Kontaktflächen wenigstens drei Erhebungen aufweist.

16. Trägerband nach Anspruch 15, bei welchem jede flache Kontaktfläche derart angeordnet ist, dass eine untere Schulter vorhanden ist, die zu dem anderen Schenkel hin gerichtet ist, auf dem sich ein Kondensator abstützen kann.

17. Trägerband nach einem der Ansprüche 1 bis 16, dadurch gekennzeichnet, dass die jeweiligen Breiten der oberen und unteren Ausschnitte kleiner als der oder gleich dem ist, welcher die Schenkel der Nadel voneinander trennt, wenn sie zueinander parallel gerichtet sind.

18. Verwendung eines Trägerbandes nach einem der vorstehenden Ansprüche für die Herstellung von Kondensatoren.

## Claims

1. Carrier strip for the connection of a capacitor or any type of component requiring a connection by pinching of and/or soldering on two opposed faces thereof, comprising a plane carrier provided with pairs of notches which are regularly distributed along the carrier, each pair of notches being formed of an upper notch and a lower notch adapted to receive needly type U-shaped connections the two lateral legs of which traverse said notches and are guided thereby, each capacitor having to be subsequently fixed between the two legs of the needle and substantially at the end thereof, characterized in that the upper notch (3) is wider than the lower notch (4), in such a manner that the needle being introduced with the base of the U lying on the side of the upper notch, the penetration of the legs into the upper and lower notches causes a progressive contraction thereof.

2. Carrier strip according to Claim 1, characterized in that each notch is formed of a plurality of sub-notches.

3. Carrier strip according to any of Claims 1 or 2, characterized in that each notch or sub-notch is formed by a perforation.

4. Carrier strip according to any of Claims 1 to 3, characterized in that each notch or sub-notch is formed of a projecting part tightening itself about the legs of the needles.

5. Carrier strip according to any of Claims 1 to 4, characterized in that each upper notch is disposed substantially above the lower corresponding notch and substantially parallel to the edge of the carrier strip.

6. Carrier strip according to any of Claims 1 to 5, characterized in that each notch has the shape of a U, the legs of which extend parallel to each other.

7. Carrier strip according to Claim 6, characterized in that the branches of each notch are directed from the upper notch towards the lower notch.

8. Carrier strip according to any of Claims 1 to 7, characterized in that, proportionally, the difference between the width of the upper notch and that of the lower notch varies between 0.05 and 5 mm, preferably between 0.1 and 1 mm, for a distance between the notches equal to 15 mm.

9. Carrier strip according to any of Claims 6 to 8, characterized in that the upper notches and lower notches are respectively aligned.

10. Carrier strip according to Claim 9, characterized in that the ends of the branches of each notch, upper and lower, respectively, are aligned.

11. Carrier strip according to Claim 10, characterized in that it has been folded along the ends of the branches of the U-shaped notch, thus defining a cavity of a height which is substantially equal to the height of the branches of the U-shaped notch.

12. Carrier strip according to any of Claims 1 to 11, equipped with at least one needle located in the corresponding notches, characterized in that the ends of the legs of said needles are provided with means for fixing a capacitor.

13. Carrier strip according to Claim 12, characterized in that the fixing means are camberings of the legs.

14. Carrier strip according to any of Claims 12 or 13, characterized in that the fixing means are obtained by flattening the ends of the legs thus forming a flat.

15. Carrier strip according to Claim 14, characterized in that the entirety of the flats has at least three protrusions.

16. Carrier strip according to Claim 15, wherein each flat is disposed in such a manner that there is a lower shoulder directed towards the other leg on which a capacitor can bear.

17. Carrier strip according to any of Claims 1 to 16, characterized in that the respective widths of the upper and lower notches are smaller than or equal to the distance separating the legs of the needle when they are directed parallel to each other.

18. Use of a carrier strip according to any of the preceding claims for the production of capacitors.

# FIG_1

# FIG_2

# FIG_3

# FIG_4

# FIG_5

# FIG_6